# EUROPEAN PATENT SPECIFICATION

(11) **EP 1 091 811 B1**
(45) Date of publication and mention of the grant of the patent: **13.07.2005**
(21) Application number: 99912557.8
(22) Date of filing: 15.03.1999
(51) Int. Cl.: B08B 3/02, H01L 21/3213

(54) **SELECTIVE TREATMENT OF THE SURFACE OF A MICROELECTRONIC WORKPIECE**
SELEKTIVE BEHANDLUNG DER OBERFLÄCHE EINES MIKROELEKTRONISCHEN WERKSTÜCKS
TRAITEMENT SELECTIF DE LA SURFACE D'UNE PIECE MICROELECTRONIQUE

(30) Priority: 13.03.1998 US 41901; 13.03.1998 US 41649; 10.07.1998 US 113435; 22.01.1999 US 116750 P; 27.01.1999 US 117474 P
(43) Date of publication of application: 18.04.2001
(73) Proprietor: SEMITOOL, INC., Kalispell, Montana 59901 (US)
(72) Inventor: AEGERTER, Brian, Kalispell, MT 59901 (US); DUNDAS, Curt, T., Kalispell, MN 59901 (US); JOLLEY, Michael, Kalispell, MT 59901 (US); RITZDORE, Tom, L., Bigfork, MT 59911 (US); CURTIS, Gary, L., Kila, MT 59920 (US)
(74) Representative: Viering, Jentschura & Partner
(86) International application number: PCT/US1999/005674
(87) International publication number: WO 1999/046064

(56) References cited:
- EP-A- 0 924 754
- EP-A- 1 037 261
- DE-A- 4 109 955
- DE-A- 4 202 194
- JP-A- 1 120 023
- JP-A- 5 013 322
- JP-A- 5 326 483
- JP-A- 6 045 302
- JP-A- 62 166 515
- US-A- 4 439 243
- US-A- 4 439 244
- US-A- 4 732 785
- US-A- 4 790 262
- US-A- 4 838 289
- US-A- 4 903 717
- US-A- 5 349 978
- US-A- 5 474 807
- PATENT ABSTRACTS OF JAPAN vol. 1997, no. 11, 28 November 1997 (1997-11-28) -& JP 09 181026 A (TOSHIBA CORP), 11 July 1997 (1997-07-11)
- PATENT ABSTRACTS OF JAPAN vol. 1997, no. 02, 28 February 1997 (1997-02-28) & JP 08 279494 A (SEIKO EPSON CORP), 22 October 1996 (1996-10-22) -& US 6 004 631 A (SEIKO EPSON CORPORATION) 21 December 1999 (1999-12-21)

## Description

### BACKGROUND OF THE INVENTION

This invention pertains to treating a silicon wafer so as to remove a thin film, such as a copper film, from regions on the silicon wafer.

The fabrication of a microelectronic circuit and/or component from a substrate typically involves a substantial number of processes. Many of these processes involve the deposition of a thin film on the surface of the workpiece followed by contact with a processing liquid, vapor, or gas. In a known process for treating a microelectronic workpiece, such as a silicon wafer, on which microelectronic devices have been fabricated and which has a front, device side, a back, non-device side, and an outer perimeter, thin-film layers are successively applied and etched to form, for example, a metallized interconnect structure. In a typical metallization process, a barrier layer is applied over a dielectric layer to the front side of the workpiece. Depending upon the particular process used to form the interconnect structures, the dielectric layer may include a pattern of recessed micro-structures that define the various interconnect paths. A thin metal film, such as a copper film, is applied exterior to the barrier layer. In most instances, the thin film serves as an initial seed layer for subsequent electroplating of a further metal layer, such as a further copper layer. Due to manufacturing constraints, the thin film is not applied over an outer, peripheral margin of the front side.

Known techniques, such as physical vapor deposition (sputtering) or chemical vapor deposition, are typically used to apply the barrier layer and the thin film. In instances in which a further metal layer is to be electroplated exterior to the thin film, one or more electrical contacts are connected to an outer margin of the thin film to provide plating power.

The surface area of the front side beyond the inner boundary of the outer margin of the thin film is not available for fabricating the microelectronic devices since the present manufacturing processes limit the extent to which device structures can be formed at the outer margin. It would be highly desirable and would result in increased yield if more of the surface area beyond the present limits of the outer margin of the thin film were available for fabricating interconnect structures.

In the known process discussed above, and in other processes, contamination by copper, other metals, or other contaminants can occur on the back side of the workpiece. Although copper and other metals tend to diffuse rapidly through silicon or silicon dioxide, the back side is generally not provided with barrier layers that are capable of preventing copper, other metals, or other contaminants from diffusing through the silicon wafer to the front side, at which such contamination can be very detrimental to device performance.

Such contamination can result from overspraying or other processing artifacts or from cross-contamination via fabrication tools. Such contamination can occur on the outer perimeter of a silicon wafer as well as on its back side. If not removed, such contamination can lead to cross-contamination of other wafers, via fabrication tools. Such contamination can be very difficult to remove, particularly if the contaminant has formed a stable silicide. It would be highly desirable if such contamination could be easily removed in a controlled manner without detrimentally affecting the front side of the workpiece.

US 5 474 807 describes applying a solvent onto a coated substrate, to dissolve the coating at peripheral, side and back portions of the substrate. The solvent does not travel to the center region of the substrate due to surface tension.

US 4 732 785 applies a solvent to a spinning substrate during a backwash step. Successive treatments at lower speeds are used to remove or reduce an edge bead.

JP 08 279 494 describes a method for removing undesired matters from a circumferential region of a substrate. An activation gas blows over a circumferential region and is removed by an exhauster, thus preventing the activation gas from leaking to the central region of the substrate.

DE 4 202 194, being the base of the preamble of claim 1, describes partial removal of a thin layer from a substrate by rotating the substrate and applying a solvent or etchant to the edge region. The surface is partially masked by a patterned mask which restricts flow of the solvent by capillary action.

EP 1 037 261 describes etching and cleaning methods where an edge nozzle emits a liquid toward a peripheral surface area of the wafer to remove unnecessary material. A surface nozzle may additionally be provided to emit a protecting liquid toward a surface center of the wafer, to protect the center from the etching/cleaning liquid.

EP 0 924 754 describes a low temperature method for CVD copper removal where sensitive areas of the wafer are protected with water spray as a copper etchant is applied.

US 4 439 243 describes a method for removing material at the outer edge of an object by contact and moving the solvent onto the edge by centrifugal force. Centrifugal force causes the solvent to move outward onto the edge of the object.

US 4 439 244 describes a similar method by applying a fluid or solvent to an object by moving the solvent onto the edge of the object by centrifugal force.

US 4 838 289 also describes a similar method wherein a solvent is applied to an object by moving the solvent onto the edge by centrifugal force.

### SUMMARY OF THE INVENTION

This invention provides a process for better treating a workpiece having a front , side, a back side, and an outer perimeter. Workpiece is defined as an object that at least comprises a substrate, and may include further layers of material or manufactured components, such as one or more metallization levels, disposed on the substrate. In accordance with the process, a processing fluid is selectively applied or excluded from an outer peripheral margin of at least one of the front or back sides of the workpiece. Exclusion and/or application of the processing fluid occurs by applying one or more processing fluids to the workpiece as the workpiece and corresponding reactor are spinning about an axis of rotation that is generally parallel (or antiparallel) to the vector defining the face of the workpiece being processed. The flow rate of the one or more processing fluids, fluid pressure, and/or spin rate are used to control the extent to which the processing fluid is selectively applied or excluded from the outer peripheral margin.

In accordance with one embodiment of the disclosed process, a thin film is applied over the front side and over at least a portion of the outer perimeter. Usually, a barrier layer is applied over the front side and over at least a portion of the outer perimeter, whereupon a further thin film, such as a conductive seed layer, is applied over the barrier layer.

After one or more further intervening steps, such as electroplating of a metal layer onto the conductive seed layer, an etchant capable of removing one or more of the thin film layers is caused to flow over an outer margin of the front side while the etchant is prevented from flowing over the front side except for the outer margin. Thus, the etchant only contacts the outer margin of the front side thereby selectively removing only the one or more thin film layers from the outer margin of the front side. If the etchant is also caused to flow over the back side and over the outer perimeter, as well as over the outer margin of the front side, the one or more thin film layers are removed from the outer perimeter and any contaminant that the etchant is capable of removing is stripped from the back side as well.

Rather than an etchant, a cleaning chemical can be used in some applications to remove or dissolve the one or more thin film layers as described above.

These and other objects, features, and advantages of this invention are evident from the following description of a preferred mode for carrying out this invention, with reference to the accompanying drawings.

### BRIEF DESCRIPTION OF THE DRAWINGS

Figures 1A, 1B, 1C, and 1D are fragmentary, cross-sectional views of a microelectronic workpiece, such as a silicon wafer, at various stages of a known sequence of processing steps in accordance with prior art.
Figures 2A, 2B, 2C, and 2D are fragmentary, cross-sectional views of a microelectronic workpiece, such as a silicon wafer, at various stages of a novel sequence of processing steps in accordance with this invention.
Figures 3 and 4 illustrate one embodiment of a reactor that can be used to implement the process of the present invention.

### DETAILED DESCRIPTION OF ONE EMBODIMENT OF THE INVENTION

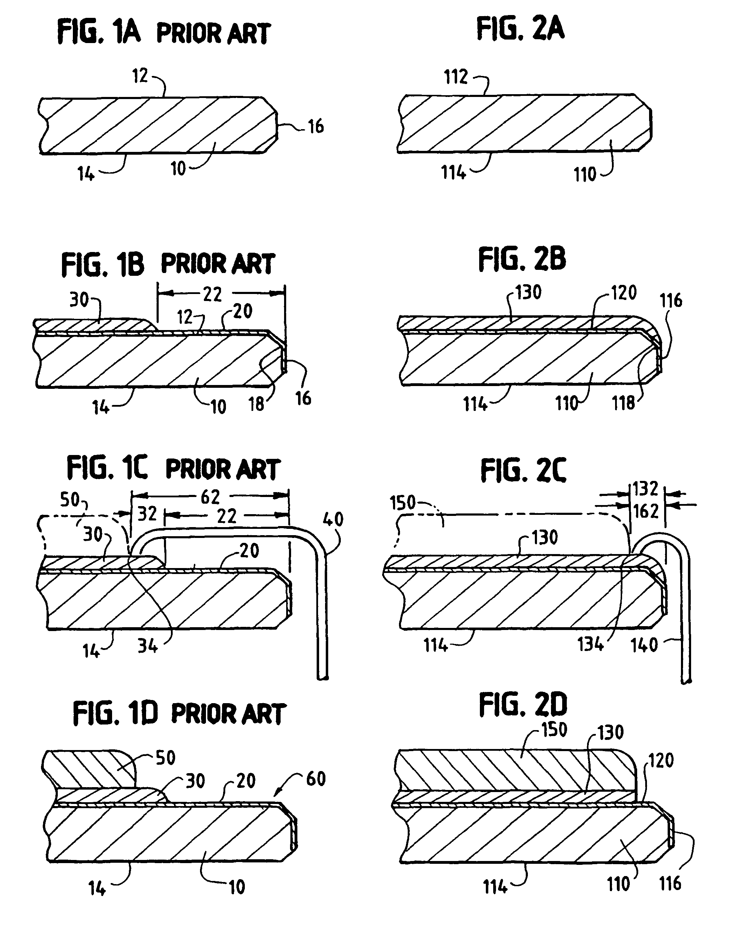

Although the process of the present invention has applicability to any process in which a processing fluid is selectively provided to or excluded from an outer margin of a workpiece, the invention will be described in connection with a sequence of processing steps for depositing one or more metallization layers or metallized structures on the workpiece. The known sequence of processing steps in accordance with the prior art begins with a silicon wafer 10, on which microelectronic devices (not shown) have been fabricated. As illustrated in Figure 1A, the wafer 10 has a front, device side 12, a back, non-device side 14, and a beveled, outer perimeter 16. Via physical vapor deposition (sputtering) or chemical vapor deposition, a barrier layer 20 is applied over the front side 12 and over an upper portion 18 of the outer perimeter 16. A thin-film seed layer , such as a copper film 30, is applied over the barrier layer 20. Conventionally, the seed layer 30 is only deposited within the bounds of an outer margin 22 of the barrier layer 20, as illustrated in Figure 1B. At an outer edge 32 of the copper film 30, one or more electrical contacts 40 to be used in providing electroplating power to the seed layer are placed in electrical contact with the copper film 30, as illustrated in Figure 1C.

After the one or more electrical contacts 40 have been connected to the seed layer copper film 30 a further copper layer 50 from which interconnect structures and/or metallized devices are fabricated is electroplated onto the wafer 110 as illustrated in Figure 1C. The electrical contact(s) 40 are then removed to provide the resultant multi-film structure, shown generally at 60 in Figure 1D. Beyond an inner boundary 34 of the outer margin 32 of the copper layer 50, an annular region 62 of the front side 12 is not available for fabricating such interconnect structures or metallized devices.

The novel sequence of processing steps in accordance with the present invention begins with a silicon wafer 110, which is similar to the silicon wafer 10 before processing, on which microelectronic devices (not shown) have been fabricated, and which has a front, device side 112, a back, non-device side 114, and a beveled, outer perimeter 116, as illustrated in Figure 2A. Via physical vapor deposition (sputtering) or chemical vapor deposition, a barrier layer 120 is applied over the front side 112 and over an upper portion 118 of the outer perimeter 116 and a thin seed layer, such as a copper film 130 is applied over the entire barrier layer 120, without exclusion from a peripheral outer margin, so as to cover the barrier layer 120 where applied over the front side 112 and over the upper portion 118 of the outer perimeter 116, as illustrated in Figure 1B. At an outer edge 132 of the copper seed layer 130, one or more electrical contacts 140 to be used in electroplating are connected to provide electroplating power to the copper film 130, as illustrated in Figure 2C. As illustrated, the outer edge 132 at which contact may be made for the supply of electroplating power illustrated in Figure 2C is substantially closer to the peripheral edge than the process as illustrated in Figure 1C.

A further copper film 150 from which metallized interconnects and/or microelectronic devices are fabricated is then applied using an electrochemical deposition process. As illustrated in Figure 2C, the further copper film 150 is deposited within the outer margin 132 of the copper film 130. The electrical contact 140 is then removed leaving the resultant multi-layer structure shown generally at 160 of Figure 2D. Metallized devices (not shown) and/or interconnects are formed by known techniques, from the resultant structure 160. After the copper layer 150 has been deposited, the seed layer 130, film 150, and/or barrier layer 120 may be removed from the outer margin 132 and, if desired peripheral edge 116 of the workpiece 110. Removal of at least layer 130 from the outer margin assists in preventing film flaking and cross-contamination problems that may occur during subsequent workpiece processing.

In accordance with the process, processing fluid is selectively applied to the outer peripheral margin of at least the front side of the workpiece. Exclus ion and/or application of the processing fluid occurs by applying one or more processing fluids to the workpiece as the workpiece and corresponding reactor are spinning about an axis of rotation that is generally parallel (or antiparallel) to the vector defining the face of the workpiece being processed. The flow rate of the one or more processing fluids, fluid pressure, and/or spin rate are used to control the extent to which the processing fluid is selectively applied to the outer peripheral margin.

A reactor suitable for executing the foregoing removal process may generally be comprised of upper and lower members that define an upper chamber and a lower chamber with respect to the workpiece contained therein. A centrally disposed inlet is provided to each of the upper an lower chambers for supplying one or more processing fluids. Fluid outlets are disposed at peripheral portions of the chambers and are adapted to assist in the exclusion of one processing fluid from the outer margin of the workpiece while allowing intrusion of an etchant thereat. The upper and lower chambers are rotated conjointly so as to distribute a processing fluid in the upper chamber across an upper side of the workpiece through centripetal acceleration and so as to distribute a processing fluid in the lower chamber across a lower side of the workpiece through centripetal acceleration. Depending upon the processes being performed, however, the processing fluids in the upper and lower chambers may be the same fluid or different fluids.

Also, rather than relying on the rotation of the workpiece, the processing fluid could also be selectively driven by pumps.

Through control of the respective pressures of the processing fluids entering the respective chambers and of the rotational speed of the rotating chambers, it is possible to control the reactor so as to cause the processing fluid entering the inlet of the lower chamber to flow over the near side of the wafer, over the outer perimeter of the workpiece, and over an outer margin of the far side of the workpiece, and so as to prevent the same processing fluid from flowing over the far side except for the outer margin. The control of the fluid pressures may be achieved for example through the use of a pump for liquids, or a pressure regulator for a pressurized gas source.

The process provided by this invention can be advantageously practiced in a reactor illustrated and described in a patent application having Semitool, Inc. as the common assignee (Attorney Docket No. SEM4492P0043US). That application is entitled "REACTOR FOR PROCESSING SILICON WAFER IN MICRO-ENVIRONMENT".

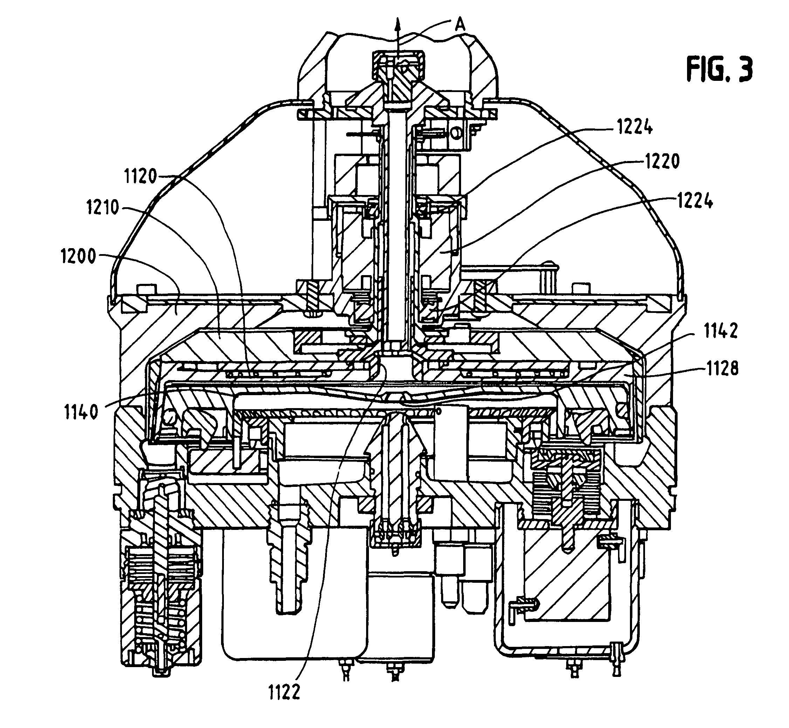

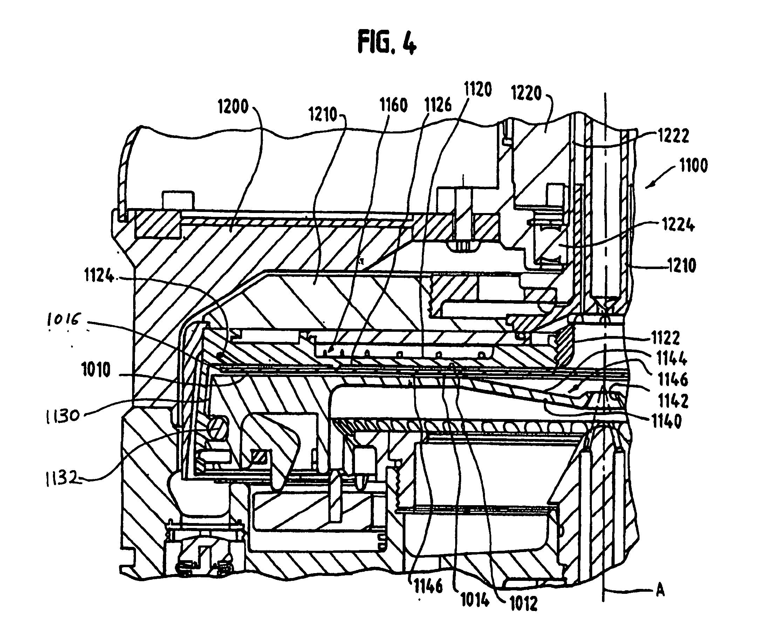

As shown in Figures 3 and 4, a reactor 1100 for processing a microelectronic workpiece, such as a silicon wafer 1010 having an upper side 1012, a lower side 1014, and an outer, circular perimeter 1016, in a micro-environment constitutes a preferred platform for the practice of the process of this invention. For certain applications, the upper side 1012 is the front side, which may be otherwise called the device side, and the lower side 1014 is the back side, which may be otherwise called the non-device side. However, for other applications, the silicon wafer 1010 is inverted.

Generally, except as disclosed herein, the reactor 1100 is similar to the reactors illustrated and described in United States Patent Application Serial No. 09/113,435. However, as illustrated in the drawings and described herein, the reactor 1100 is improved to be more versatile in executing select microelectronic fabrication processes.

The reactor 1100 has an upper chamber member that includes an upper chamber wall 1120 and a lower chamber member that includes a lower chamber wall 1140. These walls 1120, 1140, are arranged to open so as to permit a wafer 1010 to be loaded into the reactor 1100 for processing, by a loading and unloading mechanism (not shown) that, for example, may be in the form of a robot having an end effector. These walls 1120, 1140, are arranged to close so as to define a capsule 1160 supporting a wafer 1010 in a processing position, between these walls 1120, 1140.

The reactor 1010, which defines a vertical axis A, has a head 1200 containing a rotor 1210, which mounts the upper chamber wall 1120, and mounting a motor 1220 for rotating the rotor 1210 and the upper and lower chamber walls 1120, 1140, when closed, around the vertical axis A, conjointly with a wafer 1010 supported in the processing position. The head 1200 is arranged to be raised for opening these walls 1120, 1140, and to be lowered for closing these walls 1120, 1140.

The upper chamber wall 1120 has an inlet 1122 for processing fluids, which may be liquid, vaporous, or gaseous, and the lower chamber wall 1140 has an inlet 1142 for such fluids, which for a given application may be similar fluids or different fluids. The head 1200 mounts an upper nozzle 1210, which extends axially through the sleeve 1222 so as not to interfere with the rotation of the sleeve 1222. The upper nozzle 1210 directs streams of processing fluids downwardly through the inlet 1122 of the upper chamber wall 1120.

The upper chamber wall 1120 includes an array of similar outlets 1124, which are spaced similarly at uniform angular spacings around the vertical axis A. In the disclosed embodiment, thirty-six such outlets 1124 are employed. Each outlet 1124 is spaced outwardly from the vertical axis A by a comparatively larger radial distance and is spaced inwardly from the outer perimeter 1016 of a wafer 1010 supported in the processing position by a comparatively smaller radial distance, such as a distance of approximately 1.5 millimeters.

When the upper and lower chamber walls 1120, 1140, are closed, they define a micro-environment reactor 1160 having an upper processing chamber 1126 that is defined by the upper chamber wall 1120 and by a first generally planar surface of the supported wafer 1010, and a lower processing chamber 1146 that is defined by the lower chamber wall 1140 and a second generally planar surface of the supported wafer opposite the first side. The upper and lower processing chambers 1126, 1146, are in fluid communication with each other in an annular region 1130 beyond the outer perimeter of the supported wafer 1010 and are sealed by an annular, compressible seal (*e.g.* O-ring) 1132 bounding a lower portion of the annular region 1130. The seal 1132 allows processing fluids entering the lower inlet 1142 to remain under sufficient pressure to flow toward the outlets 1124.

As compared to reactors of the type disclosed in the above-noted patent application, the reactor 1100 is particularly suitable for executing a range of unique microfabrication processes. For example, reactor 1100 is particularly suited to execute a process such as the one set forth herein that requires complete contact of a processing fluid at a first side of a workpiece and at only a peripheral margin portion of the second side thereof. Such processes may be realized because processing fluids entering the inlet 1142 of the lower chamber wall 1140 can act on the lower side 1014 of a supported wafer 1010, on the outer periphery 1016 of the supported wafer 1010, and on an outer margin 1018 of the upper side 1012 of the supported wafer 10 before reaching the outlets 1124, and because processing fluids entering the inlet 1122 of the upper chamber wall 1120 can act on the upper side 1012 of the supported wafer 1010, except for the ou ter margin 1018 of the upper side 1012, before reaching the outlets 1124.

When the reactor illustrated and described above is employed to practice the process provided by this invention for treating a silicon wafer having a front, device side, a back, non-device side, and an outer perimeter, so as to remove a thin film, such as a copper film, the silicon wafer is placed into the reactor with its back side being the lower side. An etchant capable of removing the copper is used as the processing fluid. The etchant is delivered by a pump to the lower chamber and inert gas is used as the processing fluid entering the upper chamber. The etchant is caused to flow over the back side, over an outer perimeter of the silicon wafer, and over an outer margin of the front side, but is prevented from flowing over the front side except for the outer margin. After the etchant removes the thin film, any residual etchant is rinsed away, as with deionized water.

The processing fluid can be a mixture of an acid and an oxidizing agent.

If the thin film is a metal film, such as a copper film, a prefer red etchant is a mixture of hydrofluoric acid and hydrogen peroxide, as an oxidizing agent, most preferably 0.5% hydrofluoric acid and 10 % hydrogen peroxide, by volume, with the remainder being deionized water . An alternative reagent is approximately 10% sulfuric acid, although other concentrations of sulfuric acid from approximately 5% to approximately 98%, along with approximately 0% to 20 % of an oxidizing agent, can be instead used to remove a metal film, such as a copper film.

The processing fluid can also be a mixture of sulfuric acid and amonium persulfate.

Other alternative enchants that can be instead used to remove a metal film, such as a copper film, include mixtures of hydrofluoric acid and a surfactant, mixtures of hydrofluoric and hydrochloric acids, mixtures of nitric and hydrofluoric acids, and EKC 5000, which is a proprietary chemical available commercially from EKC of Hayward, California.

When the resultant structure 160 illustrated in Figure 2D is compared to the resultant structure 60 illustrated in Figure 1D, it is evident that the annular region 62 not available for fabricating such interconnect structures and/or metallized components from the resultant structure 160 is smaller than the annular region 62 that is not available for fabricating such interconnect structures and/or metallized components on the resultant structure 60, all other dimensions being alike. It follows that this invention enables a greater yield of microelectronic devices from a silicon wafer of a given size. Advantageously, the process provided by this invention not only removes a thin film, such as a copper film, but also removes any contaminant, such as any copper or other metal, that the reagent is capable of solvating from the back side of the silicon wafer.

The thin film removed by the process of the present invention could also be substantially comprised of silicon nitride, silicone oxide, polysilicon, or photoresist.

Various modifications can be made in the preferred mode, as illustrated and described, without departing from the scope of this invention as defined in the claims.

## Claims

1. A method for processing a microelectronic workpiece by applying a processing fluid onto the workpiece, with the workpiece having a first side, and a second side, with a metal layer on the second side, and an outer perimeter joining the first and second sides, wherein the workpiece is spinned, **characterized by**:
selectively providing a processing fluid onto the first side and allowing the fluid to move from the first side around the outer perimeter and onto only an outer margin of the second side, by controlling one or more of the fluid flow rate, the fluid pressure, and/or the spin rate; and
with the processing fluid removing any contaminant that the processing fluid is capable of etching, or otherwise removing, from the first side, and with the processing fluid also removing the metal layer from the outer margin of the second side.

2. The method of claim 1 further **characterized by** processing the workpiece in a reactor (1100) and by preventing the processing fluid from flowing over the second side, except for the outer margin, via centrifugal force resulting from the spinning of the workpiece, and by removing the processing fluid from the reactor (1100) through outlets (1124) positioned inwardly from the edge of the workpiece, so that the processing fluid does not flow over the second side except for the outer margin, and so that the metal layer is substantially removed from the outer margin without being removed from the rest of the second side.

3. The method of claim 2 wherein the outlets (1124) are also positioned vertically above the outer margin.

4. The process of claim 1 further **characterized by** the step of supplying an inert fluid onto the second side of the workpiece.

5. The process of claim 1 or 4 with the processing fluid including an oxidizing agent or hydrofluoric acid.

6. The method of claim 1 further **characterized by** the workpiece having a barrier layer and a seed layer exterior to the barrier layer, and with the metal layer on the seed layer, and with the processing fluid capable of etching at least the seed layer and the metal layer, so as to substantially remove the seed layer and metal layer from the outer margin of the second side.

7. The method of claim 6 wherein the metal layer is electroplated onto the seed layer.

8. The method of claim 1 **characterized by**:
applying the processing fluid and a further processing fluid respectively to the first and second sides of the microelectronic workpiece;
selectively providing contact between the processing fluid and the first side of the microelectronic workpiece and an outer margin of the second side of the microelectronic workpiece while, concurrently, selectively providing contact between the further processing fluid and the second side of the microelectronic workpiece to the substantial exclusion of the outer margin of the second side.

9. The method of claim 1 **characterized by**:
applying the processing fluid and a further processing fluid respectively to the first and second sides of the microelectronic workpiece;
inhibiting contact between the further processing fluid and the outer margin of the second side of the microelectronic workpiece while, concurrently, providing contact of the processing fluid with the first side of the microelectronic workpiece and outer margin of the second side of the microelectronic workpiece.

10. The method of claim 1 **characterized by**:
introducing the processing fluid at the first side of the microelectronic workpiece;
introducing a further processing fluid at the second side of the microelectronic workpiece;
driving the processing fluid to contact the first side of the microelectronic workpiece, the outer perimeter, and a peripheral margin of the second side of the microelectronic workpiece;
driving the further processing fluid to contact the second side of the microelectronic workpiece substantially only at those portions of the second side interior to the peripheral margin of the second side.

11. The method of claim 1 for 6 further **characterized by** controlling the extent to which the processing fluid is selectively applied to the outer peripheral margin, by controlling the flow rate of the processing fluid and/or the spin rate.

12. The method of claim 1 or 6 further **characterized by**:
placing the workpiece into a reactor (1100), between an upper chamber wall (1120) and a lower chamber wall (1140) of the reactor, with the upper chamber wall (1120) having outlets (1124) spaced outwardly from a spin axis of the reactor by a comparatively larger radial distance and spaced inwardly from the outer perimeter (1016) of the workpiece by a comparatively smaller radial distance;
rotating the upper and lower chamber walls conjointly with the workpiece about the spin axis;
providing the processing fluid onto the first side (114) of the workpiece and an outer margin of the second side, through an inlet (1142) in the lower chamber member; and
preventing the processing fluid from flowing over the second side except for the outer margin, by having the processing fluid flow radially outwardly on the first side of the workpiece, around the perimeter of the workpiece, onto the outer margin of the second side, and then out through the outlets (1124), so as to substantially remove the metal layer from the outer margin of the second side.

13. The method of claim 6 wherein the barrier layer (120) is applied over the second side (112) and over an upper portion (118) of the outer perimeter (116), and the seed layer (130) is applied over the entire barrier layer (120), without exclusion from a peripheral outer margin, so as to cover the barrier layer (120) where applied over the second side (112) and over the upper portion (118) of the outer perimeter (116), and the metalization layer (150) is made by connecting one or more electrical contacts (140) onto the seed layer (130) to provide electroplating power to the seed layer, with the contacts (140) near the peripheral edge of the workpiece (110), thereby leaving more surface area on the second side available for fabricating microelectronic devices.

14. The method of claim 1 further **characterized by** the second side (112) is a top side facing up;
the metal layer on the second side includes copper;
and the fluid etches away copper from the outer margin (132) of the second side, and the outer perimeter (116) of the workpiece.

15. The method of claim 1 further **characterized by** metal contamination on one or both of the first side of the workpiece and the outer perimeter (116) of the workpiece, resulting from the physical or chemical vapor deposition or plating of metal or overspraying onto the second side, or from cross contamination of fabrication tools, and further **characterized by** removing the metal contamination from one or both of the first side and the outer perimeter of the workpiece by providing the processing fluid onto them.

## Patentansprüche

1. Verfahren zum Bearbeiten eines mikroelektronischen Werkstücks mittels Aufbringens eines Bearbeitungsfluids auf das Werkstück, wobei das Werkstück eine erste Seite und eine zweite Seite, wobei sich auf der zweiten Seite eine Metallschicht befindet, und einen Außenumfang aufweist, der die erste Seite mit der zweiten Seite verbindet, und wobei das Werkstück rotiert wird, **gekennzeichnet durch**:
selektives Bereitstellen eines Bearbeitungsfluids auf der ersten Seite und Ermöglichen, dass sich das Fluid von der ersten Seite aus um den Außenumfang herum und auf lediglich einen äußeren Seitenrand der zweiten Seite bewegt, mittels Steuerns von einem oder mehreren des Fluid-Volumenstroms, des Fluiddrucks und/oder der Drehzahl, und
Entfernen jeden Kontaminationsstoffs mittels des Bearbeitungsfluids, welchen das Bearbeitungsfluid **durch** Ätzen oder anderweitig von der ersten Seite entfernen kann, und wobei das Bearbeitungsfluid ferner die Metallschicht von dem äußeren Seitenrand der zweiten Seite entfernt.

2. Verfahren gemäß Anspruch 1, ferner **gekennzeichnet durch** Bearbeiten des Werkstücks in einem Reaktor (1100) und **durch** Verhindern mittels einer aus dem Rotieren des Werkstücks resultierenden Zentrifugalkraft, dass das Bearbeitungsfluid über die zweite Seite hinweg, abgesehen vom äußeren Seitenrand, fließt, und **durch** Entfernen des Bearbeitungsfluids aus dem Reaktor (1100) **durch** Auslässe (1124) hindurch, die vom Rand des Werkstücks aus nach innen hin positioniert sind, so dass das Bearbeitungsfluid, abgesehen vom äußeren Seitenrand, nicht über die zweite Seite hinweg fließt, und so dass die Metallschicht im Wesentlichen vom äußeren Seitenrand entfernt wird, ohne vom Rest der zweiten Seite entfernt zu werden.

3. Verfahren gemäß Anspruch 2, wobei die Auslässe (1124) ferner vertikal über dem äußeren Seitenrand positioniert sind.

4. Verfahren gemäß Anspruch 1, ferner **gekennzeichnet durch** den Schritt des Zuführens eines Inertfluids auf die zweite Seite des Werkstücks.

5. Verfahren gemäß Anspruch 1 oder 4, wobei das Bearbeitungsfluid ein Oxidationsmittel oder Fluorwasserstoffsäure aufweist.

6. Verfahren gemäß Anspruch 1, ferner **dadurch gekennzeichnet, dass** das Werkstück eine Sperrschicht und eine dotierte Schicht aufweist, die sich außen auf der Sperrschicht befindet, und mit einer Metallschicht auf der dotierten Schicht, wobei das Bearbeitungsfluid zumindest die dotierte Schicht und die Metallschicht so Ätzbearbeiten kann, dass die dotierte Schicht und die Metallschicht im Wesentlichen vom äußeren Seitenrand der zweiten Seite entfernt werden.

7. Verfahren gemäß Anspruch 6, wobei die Metallschicht auf die dotierte Schicht aufgalvanisiert wird.

8. Verfahren gemäß Anspruch 1, **gekennzeichnet durch**:
Aufbringen des Bearbeitungsfluids und eines zusätzlichen Bearbeitungsfluids auf die erste Seite bzw. auf die zweite Seite des mikroelektronischen Werkstücks,
selektives Schaffen eines Kontaktes zwischen dem Bearbeitungsfluid und der ersten Seite des mikroelektronischen Werkstücks sowie einem äußeren Seitenrand der zweiten Seite des mikroelektronischen Werkstücks bei gleichzeitigem, selektiven Schaffen eines Kontaktes zwischen dem zusätzlichen Bearbeitungsfluid und der zweiten Seite des mikroelektronischen Werkstücks unter substantiellem Ausschluss des äußeren Seitenrandes der zweiten Seite.

9. Verfahren gemäß Anspruch 1, **gekennzeichnet durch**:
Aufbringen des Bearbeitungsfluids und eines zusätzlichen Bearbeitungsfluids auf die erste Seite bzw. auf die zweite Seite des mikroelektronischen Werkstücks,
Verhindern eines Kontaktes zwischen dem zusätzlichen Bearbeitungsfluid und dem äußeren Seitenrand der zweiten Seite des mikroelektronischen Werkstücks bei gleichzeitigem Schaffen eines Kontaktes des Bearbeitungsfluids mit der ersten Seite des mikroelektronischen Werkstücks und dem äußeren Seitenrand der zweiten Seite des mikroelektronischen Werkstücks.

10. Verfahren gemäß Anspruch 1, **gekennzeichnet durch**:
Einbringen des Bearbeitungsfluids auf der ersten Seite des mikroelektronischen Werkstücks,
Einbringen eines zusätzlichen Bearbeitungsfluids auf der zweiten Seite des mikroelektronischen Werkstücks,
Treiben des Bearbeitungsfluids, so dass es die erste Seite des mikroelektronischen Werkstücks, den Außenumfang und einen peripheren Seitenrand der zweiten Seite des mikroelektronischen Werkstücks kontaktiert,
Treiben des zusätzlichen Bearbeitungsfluids, so dass es die zweite Seite des mikroelektronischen Werkstücks im Wesentlichen nur an jenen Abschnitten der zweiten Seite kontaktiert, die sich einwärts des peripheren Seitenrandes der zweiten Seite befinden.

11. Verfahren gemäß Anspruch 1 oder 6, ferner **gekennzeichnet durch** Steuern des Ausmaßes, bis zu welchem das Bearbeitungsfluid selektiv auf den äußeren, peripheren Seitenrand aufgebracht wird, indem der Volumenstrom des Bearbeitungsfluids und/oder die Drehzahl gesteuert werden.

12. Verfahren gemäß Anspruch 1 oder 6, ferner **gekennzeichnet durch**:
Platzieren des Werkstücks in einem Reaktor (1100) zwischen einer oberen Kammerwand (1120) und einer unteren Kammerwand (1140) des Reaktors, wobei die obere Kammerwand (1120) Auslässe (1124) aufweist, die von der Rotationsachse des Reaktors nach außen hin in einem relativ größeren Radialabstand angeordnet sind und die vom Außenumfang (1016) des Werkstücks nach innen hin in einem relativ kleineren Radialabstand angeordnet sind,
Rotieren der oberen Kammerwand und der unteren Kammerwand gemeinsam mit dem Werkstück um die Rotationsachse,
Bereitstellen des Bearbeitungsfluids auf der ersten Seite (114) des Werkstücks und auf einem äußeren Seitenrand der zweiten Seite **durch** einen Einlass (1142) in dem unteren Kammerteil hindurch, und
Verhindern, dass das Bearbeitungsfluid über die zweite Seite, abgesehen vom äußeren Seitenrand, hinweg fließt, indem der Strom von Bearbeitungsfluid an der ersten Seite des Werkstücks radial nach außen, um den Umfang des Werkstücks herum, auf den äußeren Seitenrand der zweiten Seite und dann nach außen **durch** die Auslässe (1124) hindurch stattfindet, so dass die Metallschicht vom äußeren Seitenrand der zweiten Seite im Wesentlichen entfernt wird.

13. Verfahren gemäß Anspruch 6, wobei die Sperrschicht (120) auf der zweiten Seite (112) und auf einem oberen Abschnitt (118) des Außenumfangs (116) aufgebracht wird, und wobei die dotierte Schicht (130) ohne Ausschließen eines peripheren, äußeren Seitenrandes auf die gesamte Sperrschicht (120) aufgebracht wird, um die Sperrschicht (120), wo sie auf der zweiten Seite (112) und auf dem oberen Abschnitt (118) des Außenumfangs (116) aufgebracht ist, abzudecken, und wobei die Metallisierungsschicht (150) hergestellt wird durch Anschließen von einem oder mehreren elektrischen Kontakten (140) auf der dotierten Schicht (130), um die dotierte Schicht mit Galvanisierungsstrom zu versorgen, wobei die Kontakte (140) sich nahe des Umfangsrandes des Werkstücks (110) befinden, so dass auf der zweiten Seite mehr Fläche zum Herstellen mikroelektronischer Bauelemente verfügbar bleibt.

14. Verfahren gemäß Anspruch 1, ferner **dadurch gekennzeichnet, dass** die zweite Seite (112) eine nach oben weisende Oberseite ist, dass die sich auf der zweiten Seite befindende Metallschicht Kupfer aufweist, und dass das Fluid Kupfer vom äußeren Seitenrand (132) der zweiten Seite und vom Außenumfang (116) des Werkstücks abätzt.

15. Verfahren gemäß Anspruch 1, ferner **gekennzeichnet durch** eine Metallkontamination an einem oder an beiden von der ersten Seite des Werkstücks und dem Außenumfang (116) des Werkstücks, die aus der physikalischen Abscheidung aus der Gasphase oder der chemischen Abscheidung aus der Gasphase oder einem Abscheiden von Metall oder einem Overspray auf die zweite Seite oder aus einer Kreuzkontamination von Produktionswerkzeugen resultiert, und ferner **gekennzeichnet durch** Entfernen der Metallkontamination von einem oder von beiden von der ersten Seite und dem Außenumfang des Werkstücks **durch** Vorsehen von Bearbeitungsfluid auf diesen.

## Revendications

1. Procédé pour le traitement d'une pièce microélectronique à traiter, par application d'un fluide de traitement sur la pièce à traiter, la pièce à traiter possédant une première face et une seconde face, avec une couche métallique sur la seconde face, et une périphérie extérieure réunissant les première et seconde faces, selon lequel la pièce à traiter est entraînée en rotation, **caractérisé en ce qu'**il consiste à:
appliquer sélectivement un fluide de traitement sur la première face et amener le fluide à se déplacer depuis la première face autour de la périphérie extérieure et uniquement sur une marge extérieure de la seconde face, par commande d'une ou plusieurs variables comprenant le débit du fluide, la pression du fluide et/ou la vitesse de rotation; et
éliminer, à l'aide du fluide de traitement, toute substance polluante que le fluide de traitement est capable d'attaquer chimiquement, ou sinon d'éliminer, de la première face, et éliminer également, à l'aide du fluide de traitement, la couche métallique à partir d'une marge extérieure de la seconde face.

2. Procédé selon la revendication 1, **caractérisé en outre par** le traitement de la pièce à traiter dans un réacteur (1100) et par l'empêchement de la circulation du fluide de traitement au-dessus de la seconde face, hormis au niveau de la marge extérieure, par l'intermédiaire d'une force centrifuge résultant de la rotation de la pièce à traiter, et par le retrait du fluide de traitement à partir du réacteur (1100) par des sorties (1124) disposées à l'intérieur du bord de la pièce à traiter de sorte que le fluide de traitement ne s'écoule pas au-dessus de la seconde face hormis au niveau de la marge extérieure, et de sorte que la couche métallique est sensiblement retirée de la marge extérieure sans être retiré du reste de la seconde face.

3. Procédé selon la revendication 2, selon lequel les sorties (1124) sont également positionnées verticalement au-dessus de la marge extérieure.

4. Traitement selon la revendication 1, **caractérisé en outre par** l'étape consistant à appliquer un fluide inerte sur la seconde face de la pièce à traiter.

5. Procédé selon la revendication 1 ou 4, selon lequel le fluide de traitement inclut un agent oxydant ou de l'acide fluorhydrique.

6. Procédé selon la revendication 1, **caractérisé en outre en ce que** la pièce à traiter possède une couche formant barrière et une couche amorphe formant germe située à l'extérieur de la couche formant barrière, et avec la couche métallique sur la couche formant germe, et avec le fluide de traitement apte à attaquer chimiquement au moins la couche formant germe et la couche métallique, de manière à éliminer de façon substantielle la couche formant germe et la couche métallique à partir de la marge extérieure de la seconde face.

7. Procédé selon la revendication 6, selon lequel la couche métallique est appliquée par électroplacage sur la couche formant germe.

8. Procédé selon la revendication 1, **caractérisé par**:
l'application du fluide de traitement et d'un autre fluide de traitement respectivement sur les première et seconde face de la pièce microélectronique à traiter;
l'établissement sélectif d'un contact entre le fluide de traitement et la première face de la pièce microélectronique à traiter et une marge extérieure de la seconde face de la pièce microélectronique à traiter tout en établissant, simultanément, de façon sélective, un contact entre l'autre fluide de traitement et la seconde face de la pièce microélectronique à traiter, à l'exclusion essentiellement de la marge extérieure de la seconde face.

9. Procédé selon la revendication 1, **caractérisé par**:
l'application du fluide de traitement et d'un autre fluide de traitement respectivement aux première et seconde face de la pièce microélectronique à traiter;
l'empêchement de l'établissement d'un contact entre l'autre fluide de traitement et la marge extérieure de la seconde face de la pièce microélectronique à traiter, tout en prévoyant simultanément un contact du fluide de traitement avec la première face de la pièce microélectronique à traiter et une marge extérieure de la seconde face de la pièce microélectronique à traiter.

10. Procédé selon la revendication 1, **caractérisé par**:
l'introduction du fluide de traitement sur la première face de la pièce microélectronique à traiter;
l'introduction d'un autre fluide de traitement sur la seconde face de la pièce microélectronique à traiter;
l'entraînement du fluide de traitement pour qu'il vienne en contact avec la première face de la pièce microélectronique à traiter, la périphérie extérieure et une marge périphérique de la seconde face de la pièce microélectronique à traiter ;
l'entraînement de l'autre fluide de traitement pour qu'il vienne en contact avec la deuxième face de la pièce microélectronique à traiter essentiellement uniquement sur ces portions de la seconde face intérieures à la marge périphérique de la seconde face.

11. Procédé selon la revendication 1 ou 6, **caractérisé en outre par** la commande du degré d'application du fluide de traitement sur la marge périphérique extérieure par commande du débit du fluide de traitement et/ou de la vitesse de rotation.

12. Procédé selon la revendication 1 ou 6, **caractérisé par**:
la mise en place de la pièce à traiter dans un réacteur (1100) entre une paroi supérieure de chambre (1120) et, une paroi inférieure de chambre (1140) du réacteur, la paroi supérieure de chambre (1120) comportant des sorties (1124) distantes, vers l'extérieur par rapport à un axe de rotation du réacteur, et ce d'une distance radiale comparativement plus grande et distante, vers l'intérieur, de la périphérie extérieure (1016) de la pièce à traiter, et ce d'une distance radiale comparativement plus petite;
l'entraînement en rotation des parois supérieure et inférieure de chambre conjointement avec la pièce à traiter autour de l'axe de rotation;
l'application du fluide de traitement sur la première face (114) de la pièce à traiter et une marge extérieure de la seconde face, par une entrée (1142) dans l'élément inférieure de chambre; et
l'empêchement de la circulation du fluide de traitement sur la seconde face hormis au niveau de la marge extérieure, par le fait que le fluide de traitement circule radialement vers l'extérieur sur la première face de la pièce à traiter, autour de la périphérie de la pièce à traiter, sur la marge extérieure de la seconde face, puis sort par les sorties (1124), de manière à éliminer de façon substantielle la couche métallique à partir de la marge extérieure de la seconde surface.

13. Procédé selon la revendication 6, selon lequel la couche formant barrière (120) est appliquée sur la seconde face (112) et sur une partie supérieure (118) de la périphérie extérieure (116), et la couche formant germe (130) est appliquée sur l'ensemble de la couche formant barrière (120), sans exclure une marge extérieure périphérique, de manière à recouvrir la couche formant barrière (120), là où elle est appliquée sur la seconde face (112) et sur la partie supérieure (118) de la périphérie extérieure (116), et la couche de métallisation (150) est formée par raccordement d'un ou de plusieurs contacts électriques (140) sur la couche formant germe (130) pour appliquer une puissance d'électroplacage à la couche formant germe, avec les contacts (140) à proximité du bord périphérique de la pièce à traiter (110), ce qui laisse une plus grande étendue en surface de la seconde face, disponible pour la fabrication de dispositifs microélectroniques.

14. Procédé selon la revendication 1, **caractérisé en outre par le fait que** la seconde face (112) est une face supérieure tournée vers le haut;
que la couche métallique sur la seconde face inclut du cuivre;
et que le fluide élimine par attaque chimique le cuivre à partir de la marge extérieure (132) de la seconde face et de la périphérie extérieure (116) de la pièce à traiter.

15. Procédé selon la revendication 1, **caractérisé en outre par** une contamination métallique sur l'une ou les deux de la première face de la pièce à traiter et de la périphérie extérieure (116) de la pièce à traiter, sous l'effet du dépôt physique ou chimique en phase vapeur ou du placage d'un métal ou d'un revêtement par pulvérisation sur la seconde face, ou résultant de la contamination secondaire d'outils de fabrication, et **caractérisé en outre par** le retrait de la contamination métallique de l'une ou des deux parties comprenant la première face et la périphérie extérieure de la pièce à traiter par application du fluide de traitement à cette face et à cette périphérie.
